Europäisches Patentamt

(19) European Patent Office

Office européen des brevets

(11) Publication number: **0 175 864**
**B1**

(12) EUROPEAN PATENT SPECIFICATION

(45) Date of publication of the patent specification:
24.05.89

(51) Int. Cl.⁴: **H01L 29/08,** H01L 29/80,
H01L 21/265

(21) Application number: 85108697.5

(22) Date of filing: 12.07.85

(54) Self-aligned metal-semiconductor field effect transistor.

(30) Priority: 27.08.84 US 644830

(43) Date of publication of application:
02.04.86 Bulletin 86/14

(45) Publication of the grant of the patent:
24.05.89 Bulletin 89/21

(84) Designated Contracting States:
DE FR GB

(56) References cited:
EP-A- 0 181 091

PATENTS ABSTRACTS OF JAPAN, vol. 8,
no. 277 (E-285)[1714], 18th December 1984; & JP - A
- 59 147 464 (NIPPON DENKI K.K.) 23-08-1984
IBM TECHNICAL DISCLOSURE BULLETIN, vol. 25, no. 5,
October 1982, page 2373, New York, US; T.L. ANDRADE:
"MESFET device with reduced source and drain
capacitance"
IBM TECHNICAL DISCLOSURE BULLETIN, vol. 26, no. 4,
September 1983, pages 1988,1989, New York, US; C.F.
CODELLA et al.: "GaAs LDD E-MESFET for ultra-high
speed logic"
INTERNATIONAL ELECTRON DEVICES MEETING, San
Francisco, CA, US, 13th-15th December 1982,
pages 718-721, IEEE, New York, US; S. OGURA et al.: "A
half micron MOSFET using double implanted LDD"

(73) Proprietor: International Business Machines
Corporation, Old Orchard Road, Armonk, N.Y. 10504(US)

(72) Inventor: Codella, Christopher Frank, P.O. Box 370,
Fishkill New York 12524(US)
Inventor: Ogura, Seiki, Longhill Road, Hopewell Junction
New York 12533(US)

(74) Representative: Schröder, Otto H., Dr. Ing. et al, IBM
Corporation Säumerstrasse 4, CH-8803 Rüschlikon(CH)

## Description

The invention relates generally to semiconductor integrated circuit technology, and more specifically, to a self-aligned metal-semiconductor field effect transistor (MESFET) comprising on a semi-insulating semiconductor substrate a pair of relatively deep and highly doped source and drain regions and with a conductive gate electrode deposited thereon, a relatively shallow and lightly doped active channel region arranged between said source and drain regions and with a conductive gate electrode deposited thereon, and source and drain extensions arranged between said channel region and said source and drain regions, respectively, and forming a contiguous arrangement of said source, source extension, channel, drain extension and drain regions, these regions all being of a first conductivity type. The subject MESFET structure is particularly well suited for application in gallium-arsenide (GaAs) technology.

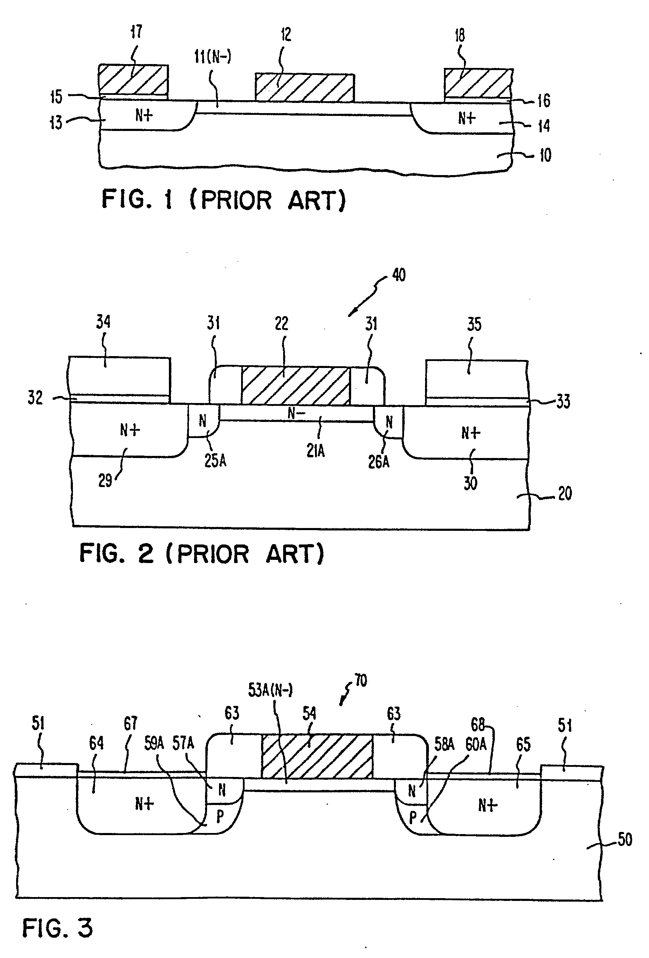

The simplest and most attractive transistor for high speed and low power GaAs digital integrated circuits is the normally-off or enhancement mode MESFET (E-MESFET). In very large scale integration (VLSI) applications, the E-MESFET is desirable since, as discussed in the article by K. Suyama et al, entitled "Design and Performance of GaAs Normally-Off MESFET Integrated Circuits", IEEE Transactions on Electron Devices, Vol. Ed-27, No. 6, pp. 1092-1097 (June 1980), it enables direct coupling of logic functions and can operate with a single positive power supply. The conventional E-MESFET structure is illustrated in a cross-sectional representation in Fig. 1. It consists of a semi-insulating GaAs substrate 10 have a $n^-$ layer 11 which is formed by either implanting n-type ions or by epitaxial growth. A gate electrode 12 is supported directly on the $n^-$ layer 11 between the heavily doped source 13 and drain 14 and forms a metal semi-conductor (Schottky) contact. The $n^-$ layer 11 is made sufficiently thin, typically as thin as 0,1 μm, and it is lightly doped, typically to a doping density of about $1 \times 10^{17}$ atoms/cm$^3$ to enable the normally-off operations of the device by enabling the depletion region under the Schottky gate 12 to pinch off the channel at zero gate voltage. The source 13 and drain 14 are heavily doped to insure good ohmic contact with their respective alloy contacts 15 and 16 which in turn make electrical contact with metal interconnects 17 and 18, respectively.

Due to its light doping and shallow depth the channel between the source and drain exhibits a high sheet resistivity. Consequently, this prior art MESFET suffers from a large source-drain series resistance which degrades the device performance. Also, the heavy doping provided in the source and drain regions, imposes restrictions on device operation. First, its places a limitation on the maximum supply voltage due to the low drain break-down voltage. Second, it requires the source and drain be spaced sufficiently far away from the gate edges to insure enhancement mode operation. This requirement further compounds the series resistance problem discussed above by increasing the length of the high resistivity channel regions. Another disadvantage of this prior art MESFET structure is that it is not amendable to a high level of circuit integration because of the rather large device size.

An improved GaAs MESFET structure is disclosed in an article "GaAs LDD E-MESFET for ultrahigh speed logic" (IBM Technical Disclosure Bulletin, Vol. 26, No. 4, September 1983, pp. 1988/89). A partial sectional view thereof is shown in Fig. 2. GaAs substrate 20 includes a self-aligned gate n-channel MESFET 40 having a relatively shallow and low dopant concentration $n^-$ channel region 21A. Positioned adjacent to the channel region 21A on either side thereof are lightly doped n-type source extension 25A and drain extension 26A. The $n^+$ doped source 29 and drain 30 are positioned adjacent extensions 25A and 26A, respectively. Overlying the channel region 21A, in a self-aligned relationship with the source 29 and drain 30 is a metal Schottky gate 22. Structure 40 further includes sidewall insulator spacers 31-31 abutting the gate 22, ohmic contacts 32 and 33 to the source 29 and drain 30, respectively, and their associated interconnecting metallization 34 and 35, respectively.

Also representative of the state-of-the art are the following further documents:

– IBM Technical Disclosure Bulletin, Vol. 25. October 1982, pp. 2373–2374, which discloses a MESFET with a layer of opposite conductivity abutting the source and drain regions, for reducing the capacitance thereof;
– JP-A-59-147, 464, which discloses a FET device with buried regions of the opposite conductivity type under and in contact with the source and drain regions, for reducing the short channel effect.

It is a principal object of the present invention to provide a high performance self-aligned GaAs MESFET device having a reduced series resistance and short channel length.

Another object is to provide a MESFET structure in which device punch-through is prevented and parasitic substrate currents are reduced which otherwise tend to degrade the device operation at submicronmeter channel length.

The invention as claimed is intended to meet these objectives and to provide for a further improved MESFET device in which hitherto encountered drawbacks are eliminated or reduced. The advantages offered by the invention are mainly that, with very short channel devices the short channel effects are reduced by preventing the drain electric field from extending into the active channel region underneath the gate. The diminished short channel effects translate into improved threshold voltage control.

One way of carrying out the invention is described in detail below with reference to drawings in which

Fig. 1 and 2 are cross-sectional views of prior art MESFET structures.

Fig. 3 is a cross-sectional representation of an embodiment of a self-aligned MESFET in accordance with the invention.

Figs. 3A-3F are sequential cross-sectional representations of the process steps of the present invention culminating in the structure shown in Fig. 3.

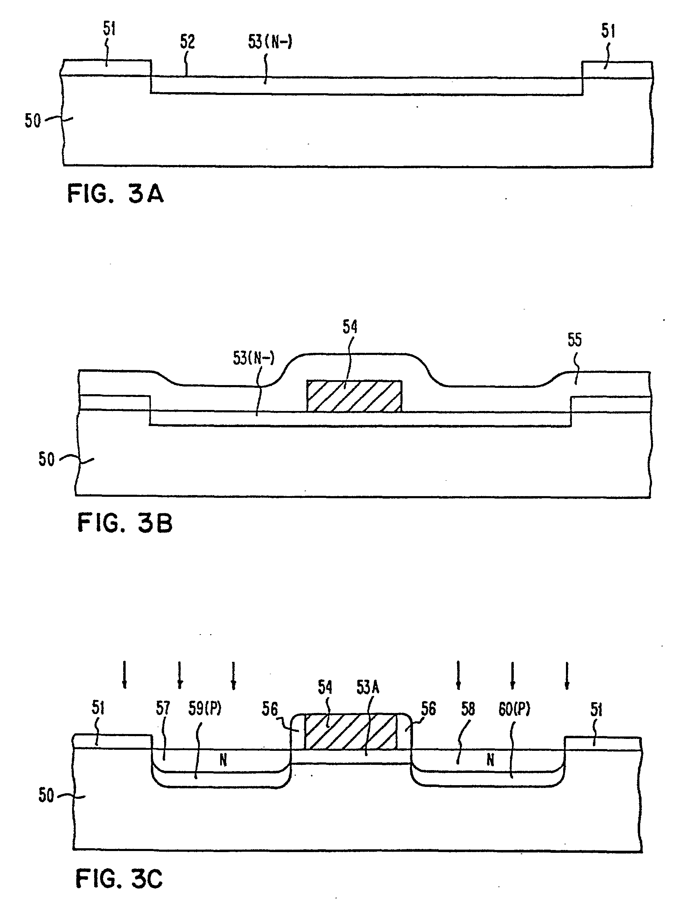

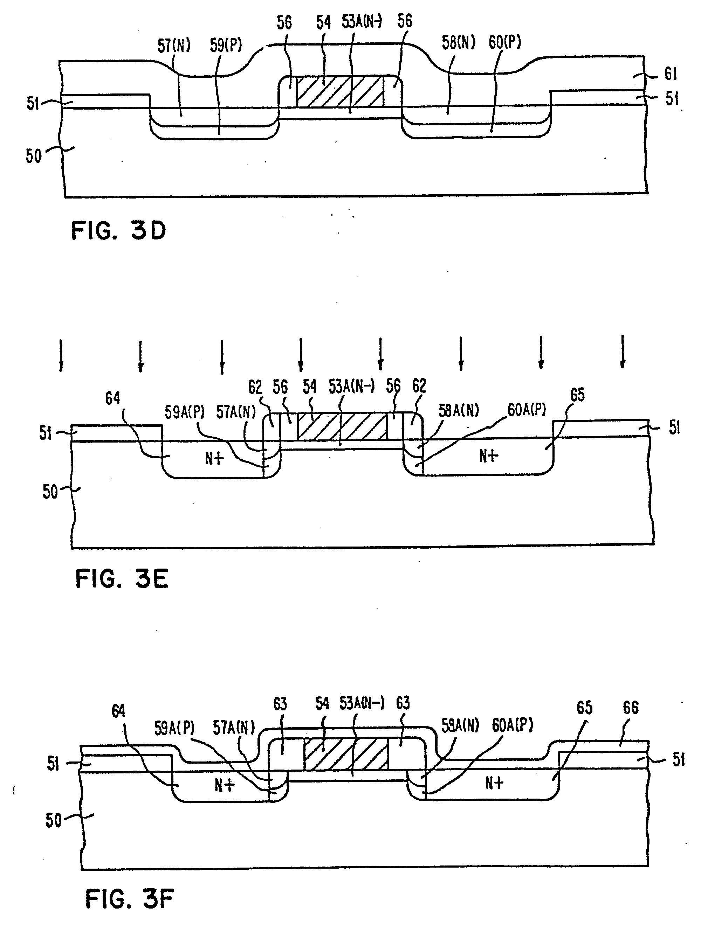

An embodiment of the invention is illustrated in Fig. 3 which shows a partial sectional view of an enhancement mode E-MESFET. Structurally, the device consists of a shallow $n^-$ channel region formed on a semi- insulating GaAs substrate, a Schottky metal gate overlying the $n^-$ channel region and relatively highly doped and deep $n^+$ source and drain regions formed in the substrate in a spaced-apart relationship with and on either side of the gate. In the channel regions between the gate edges and source/drain are positioned n-type source/drain extensions of an intermediate depth and doping concentration. The source/drain extensions constitute the lightly doped drain regions of the MESFET and serve to minimize the device series resistance, suppress short channel effects without affecting the enhancement mode operation and permit the device channel length reduction to submicron levels. The structure additionally comprises deep p-type pockets under the lightly doped n-extensions abuing the source/drain to enable better device threshold voltage control and thereby enable further reduction in the channel length.

In the embodiment of Fig. 3, the n-channel E-MESFET 70 consists of a shallow (typically less than 1 $\mu$m depth) and very lightly doped (dopant concentration in the range of $1 \times 10^{16}$ - $5 \times 10^{16}$ atoms per $cm^3$) $n^-$ regions 53A formed on a semi-insulating GaAs substrate 50 having a sheet resistance of typically about 1 Meg Ohm-cm or more. Abutting the channel region 53A, in a contiguous relationship therewith are n-type lightly doped (typically to a doping concentration of $1 \times 10^{17}$ - $1 \times 10^{18}$ atoms/$cm^3$) source extension 57A and drain extension 58A of intermediate depth (typically in the range 0.10 - 0.20 $\mu$m) and highly doped (typically to a doping concentration exceeding $1 \times 10^{18}$ atoms/$cm^3$) and deep (typically 0.20 - 0.30 $\mu$m) source 64 and drain 65 regions. Provided under the source/drain extensions 57A and 58A are deep p-type pockets 59 and 60, respectively. Overlying the channel region 53A is a conductive Schottky gate 54 which is self-aligned with the source 64 and drain 65.

Reference is now made to Figs. 3A-3F wherein the successive steps of the fabrication process of the above described embodiment (Fig. 3) of the present invention are illustrated in detail. These successive steps are listed in Table I indicating the correspondence between the steps and Figs. 3A-3F.

Table 1

| Step No. | Description of the process step |
|---|---|
| 1 | Active layer definition and formation (Fig. 3A) |
| 2 | Schottky gate formation (Fig. 3B) |
| 3 | First conformal insulator deposition (Fig. 3B) |
| 4 | First sidewall insulator spacer definition (Fig. 3C) |
| 5 | Shallow n-type source/drain extension and deep p-type pocket formation (Fig. 3C) |
| 6 | Second conformal insulator deposition (Fig. 3D) |
| 7 | Second sidewall insulator spacer definition (Fig. 3E) |
| 8 | Source/drain formation (Fig. 3E) |
| 9 | Deposition of Pt and PtAs$_2$ formation (Fig. 3F) |
| 10 | Removal of unreacted Pt (Fig. 3) |

While the following description is primarily directed to the fabrication of an E-MESFET, this description is exemplary of the fabrication of a class of devices which embody the principles of the present invention. In addition, it should be noted that the thickness and other dimensions shown herein are selected for clarity of illustration and not to be interpreted in a limiting sense.

The fabrication process of the E-MESFET 70 starts, as illustrated in Fig. 3A with forming a passivation surface layer of silicon dioxide $SiO_2$ or silicon nitride $Si_3N_4$ over a semi-insulating GaAs substrate 50 and defining by photolithographic and etching techniques an active area 52 of the substrate 50 (Step 1). The passivation surface layer that remains at the completion of this step is designated by numeral 51. The remnant layer 51 is left in tact to prevent subsequently formed metallization (Step 9) from being formed in the isolation regions thereunder which would occur if layer 51 were removed. Further, non-removal of the layer 51 saves a mask step which would be necessary if layer 51 were removed since the device isolation regions would be required to be appropriately protected during metallization.

Next, referring to Fig. 3A, the shallow and low conductivity n⁻ layer 53 is formed by implanting n-type ions such as silicon or germanium directly into the exposed substrate. The energy and dose of ions implanted are chosen such that the semiconducting n⁻ GaAs layer 53 resulting therefrom is shallow having a depth of less than 0.1 μm and has a relatively low dopant concentration in the range of about $1 \times 10^{16}$ - $1 \times 10^{17}$ atoms/$cm^3$. The n⁻ layer 53 may also be formed by other techniques such as molecular beam epitaxy, liquid phase epitaxy, metal organic vapor epitaxy or chemical vapor deposition.

Next, referring to Fig. 3B, the Schottky gate 54 is formed at a selected location directly on the active channel layer 53 by blanket depositing a conductive material such as aluminium, titanium or titanium-tungsten and defining the gate therefrom by conventional photolithographic and etching techniques (Step 2). Alternatively, the gate 54 can be formed by the lift-off technique consisting of forming a photoresist layer over the layer 53, removing the photoresist from the region where the gate electrode is to be formed, blanket depositing a layer of conductive material over the exposed layer 53 and the remaining photoresist layer and removing the photoresist and the conductive layer thereover. The gate electrode 54 has a substantially horizontal upper surface and substantially vertical side surfaces.

The succeeding step in the process, which is illustrated in Fig. 3B is the formation of a conformal insulator layer 55 such as silicon dioxide or silicon nitride over the gate electrode 54 and the layer 53 not covered by gate 54 (Step 3). If the layer 55 is silicon dioxide, one example of forming the layer 55 is by chemical vapor deposition using silane at a low pressure and temperature. As shown in Fig. 3B, the conformal insulator layer 55 consists of substantially horizontal and vertical surfaces. The thickness of layer 55 is typically in the range 0.2 - 0.5 μm.

Next, the structure is subjected to anisotropic reactive ion etching (RIE) to substantially remove the insulator layer 55 from the horizontal surfaces and to form the sidewall spacers 56-56 abutting the vertical surfaces of the gate 54 (Step 4). The resulting structure is shown in Fig. 3C. The sidewall spacers 56-56 are preferred to have a thickness about 0.1 μm or less. The thickness dimension is constrained by manufacturing reproducibility and by other considerations which include, on the one hand, the desirability of having thin sidewall spacers so as to reduce both the overall MESFET device dimensions and the undesirable channel series resistance as well as the accompanying parasitic capacitance, both of which tend to limit the MESFET performance; and on the other hand, the need to have thick sidewalls 56-56 to ensure that the gate 54 (Fig. 3C) does not substantially reach the (subsequently formed) source and drain extensions (designated by numerals 57 and 58 in Fig. 3C, for example) extending beneath the sidewall spacer 56-56 as a result of later diffusion. The latter is important to premature break-down of the MESFET device.

The succeeding process step which is also illustrated in Fig. 3C is a double implantation step (Step 5) consisting of a relatively low energy and dose n-type ion implantation to form source and drain extensions 57 and 58, respectively, and a relatively high energy and dose p-type ion implantation to form the p-type pockets 59 and 60 extending under the source and drain extensions 57 and 58 respectively. Typical n-type implantation species include Si and Ge having a dose in the range $1 \times 10^{12}$ - $1 \times 10^{13}$ atoms/$cm^2$ and energy of about 60 Kev. Typical p-type implantation species to accomplish step 5 include zinc and cadmium having a dose of at least about $1 \times 10^{12}$ atoms/$cm^2$ and energy in the range 100-150 Kev. In this process step (Step 5), it is immaterial in what order the n-type and p-type implantations are accomplished. It should be noted that the n-type source and drain extensions 57 and 58, respectively, are of a depth and dopant concentration exceeding those of the n⁻ channel region 53A.

In progressing toward the structure of Fig. 3D, the next process step is the formation of a second conformal insulator layer 61 not only over the gate 54 and its abutting sidewall spacers 56-56, but also over the source/drain extensions 57 and 58, respectively (Step 6). This step (Step 6) is typically accomplished in the same fashion as the first conformal insulator layer formation (Step 3).

In Step 7 which is illustrated in Fig. 3E, the conformal layer 61 is subjected to a RIE process step along the lines of Step 4 to form a second sidewall spacer 62-62 abutting the previous sidewall spacer 56-56. The thickness of the sidewall spacer 62-62 is governed by the same considerations discussed above in connection with the spacer 56-56.

The enlarged sidewall spacer which is a combination of spacers 56 and 62 is designated by numeral 63-63 (Fig. 3F). Once spacer 63-63 is formed masking a portion 57A of the source extension 57 and a portion 58A of the drain extension 58 adjacent the n⁻ layer 53A, the structure is subjected to a high energy and dose n-type ion implantation step (Step 8) to form the deep and heavily doped source and drain regions 64 and 65, respectively. The species for forming the source 64 and drain 65 include ions of silicon and germanium. The energy and dose of the ions used to form the source 64 and drain 65 are selected such that the depth and doping concentration of the source 64 and drain 65 exceed those of the source and drain extensions 57A and 58A, respectively.

During this process step, the sidewall spacers protect portions 57A and 58A of the n-type source and drain extensions 57 and 58, respectively, and portions 59A and 60A of the p-type pockets 59 and 60, respectively, from receiving further ion implantation. The dose of the n-type ions (typically, silicon of germanium) used in this step is adjusted such that at the completion of the step, the previously p-type doped pocket regions not masked by the sidewall spacers are not only compensated for, but also the resultant impurity type of the implanted regions 64 and 65 is rendered overwhelmingly n-type. The relative depths of the n-type doped regions 57A, 59A and 64 (Fig. 3E) etc., are dictated by the particular device application and the desired device characteristics. For example, if parasitic substrate current is a particular concern, making 59A deeper than 64 will help reduce it.

After implanting the source 64 and drain 65, the structure is subjected to a low temperature anneal step to activate the impurities implanted not only in the source 64 and drain 65, but also those in the course extension 57A and drain extension 58A. This thermal anneal step may be accomplished at a temperature of about 800°C either by capping the entire structure with a layer of silicon nitride or capless under an arsenic gas over pressure.

Referring to Fig. 3F, the next sequence of process steps is establishing self-aligned platinum diarsenide (PtAs$_2$) contacts with the source 64 and drain 65 (Steps 9 and 10). In Step 9, platinum is blanket deposited over the entire structure forming a thin conductive layer 66 thereon. The structure is then subjected to a thermal step at a temperature of about 300 to 350° C to react the platinum layer 66 formed over the source and drain regions 64 and 65, respectively, with the arsenic atoms in these regions forming a thin layer of platinum diarsenide. The unreacted platinum is then removed (Step 10) by etching it away in aqua regia which is a solution of water ($H_2O$), nitric acid ($HNO_3$) and hydrochloric acid (HC1) in the proportion of $H_2O:HNO_3:HC1$ of 1:1:2. The resulting structure which is illustrated in Fig. 3 consists of highly conductive, self-aligned PtAs$_2$ source and drain contacts 67 and 68, respectively.

In summary, the E-MESFET fabricated by the above novel process involving sidewall spacer technology, due to its self-aligned feature and relatively shallow, short (possibly less than 0.1 µm) and lightly doped channel and its adjacent deeper and relatively highly doped source and drain extensions, has a greatly reduced series resistance making the devide particularly suitable for high speed logic applications. Another beneficial feature is that the double implanted source/drain reduces the peak electric field at the drain by spreading out the depletion regions through the n-type drain extension. Consequently, the breakdown voltage is increased permitting higher drain voltage and better performance. The smaller peak electric field at the drain also results in high mobility. The self-aligned E-MESFET structure also occupies less chip area thereby enabling a higher level of integration than hitherto possible.

The deep p-type pockets underneath the source and drain extension further reduce the above short channel effects by further preventing the drain electric field from extending into the active channel (i.e. region under the gate). The diminished short channel effects means better threshold voltage control, etc.

Although the invention has been described in connection with an enhancement mode MESFET, the basic structure disclosed in Fig. 3 can be conveniently modified to form depletion mode or normally-on D-MESFETs. The depletion mode device can be formed by making the shallow n⁻ channel region 53A in Fig. 3 more highly doped and/or deep. This may require an additional mask step. The resulting D-MESFET will have all the beneficial features discussed above in connection with the counterpart enhancement mode device and will be suitable for high speed and low power enhancement/depletion circuit applications.

## Claims

1. A self-aligned metal-semiconductor field effect transistor (MESFET) comprising on a semi-insulating semiconductor substrate (50)
   – a pair of relatively deep and highly doped dource and drain regions (64, 65),
   – a relatively shallow and lightly doped active channel region (53A) arranged between said source and drain regions and with a conductive gate electrode deposited thereon, and
   – source (57A) and drain (58A) extensions arranged between said channel region and said source and drain regions, respectively, their depth and dopant concentration being inbetween those of the channel region and the source and drain regions, said source (64), source extension (57A), channel (53A), drain extension (58A) and drain (65) regions all being of a first conductivity type and forming a contiguous arrangement,
   characterized in that the MESFET furthermore comprises highly doped pockets (59A, 60A) of a second conductivity type arranged underneath each of said source (57A) and drain (58A) extensions in a contiguous relationship with said source and drain regions, respectively.

2. A MESFET as claimed in Claim 1, wherein said semiconductor substrate (50) comprises gallium arsenide.

3. A MESFET as claimed in Claim 1, wherein said first conductivity type is n-type.

4. A MESFET as claimed in Claim 1, wherein the dopant concentration in said channel region (53A) is in the range of $1 \times 10^{16}$ to $5 \times 10^{16}$ atoms/cm³.

5. A MESFET as claimed in Claim 1, wherein the dopant concentration in said source and drain extensions (57A, 58A) is in the range of $1 \times 10^{17}$ to $1 \times 10^{18}$ atoms/cm³.

6. A MESFET as claimed in Claim 1, wherein the dopant concentration in said source (64) and drain (65) regions is greater than $1 \times 10^{18}$ atoms/cm$^3$.

7. A MESFET as claimed in Claim 1, wherein the dopant concentration in said pockets (59, 60) is greater than $1 \times 10^{18}$ atoms/cm$^3$.

8. A process for forming a MESFET on a semi-insulating gallium arsenide substrate, said process comprising the steps of

a) forming a relatively shallow and lightly doped layer (53) of a first conductivity type on said substrate (50),

b) forming a conductive gate electrode (54), having a substantially horizontal upper surface and substantially vertical side surfaces, in direct contact with and over a portion of said active layer (53);

c) forming a first conformal dielectric layer (55) over the resulting structure;

d) etching directionally using reactive ion etching to remove substantially said first dielectric layer (55), forming narrow dimensioned first dielectric sidewalls (56–56) on said vertical surfaces of the gate (54);

e) forming source (57) and drain (58) extension regions by introducing dopant of the first conductivity type into the portion of the active layer (53) not masked by said gate (54) and its associated first dielectric sidewalls (56–56), said extension regions having a depth and doping concentration exceeding those of the active layer;

f) forming pocket regions (59, 60) of a second conductivity type underneath the source (57) and drain (58) extension regions by introducing dopant of a second conductivity type into said semiconductor body (50) via said source and drain extension regions, said pocket regions having a doping concentration exceeding that of the source and drain extension regions.

g) forming a second conformal dielectric layer (61) over the resulting structure;

h) etching directionally using reactive ion etching to remove substantially said second dielectric, forming second dielectric sidewalls (62–62) abutting said first dielectric sidewalls (56–56); and

i) forming source (64) and drain (65) regions of said first conductivity type by introducing dopant of the first conductivity type into the portions of the source (57) and drain (58) extension regions and of the underlying pocket regions (59, 60) of the second conductivity type not masked by the second dielectric sidewalls (62–62), said source and drain regions being of a depth and dopant concentration exceeding those of the masked source and drain extension regions (57A, 58A).

9. A process as claimed in Claim 8, further comprising the steps of

j) forming a layer (66) of platinum over the resulting structure;

k) subjecting said structure to a low temperature heating step to react the bottom portion of the platinum layer in contact with said source (64) and drain (65) regions thereby forming self-aligned platinum diarsenide ohmic contacts with said source and drain regions; and

l) removing the unreacted platinum.

**Patentansprüche**

1. Selbstjustierter Metall-Halbleiter-Feldeffekttransistor (MESFET) mit, auf einem halbisolierenden Halbleitersubstrat (50) aufgebracht,

– einem Paar relativ tiefer, hoch-dotierter Quellen- und Drain-Bereiche (64, 65),

– einem relativ flachen, niedrig dotierten aktiven Kanal-Bereich (53A), der zwischen den Quellen- und Drain-Bereichen angeordnet ist und auf dem eine leitende Gateelektrode aufgebracht ist, und

– Quellen- (57A) und Drain- (58A) Erweiterungen, die zwischen dem Kanalbereich und den Quellen- bzw. Drain-Bereichen angeordnet sind, und deren Tiefe und Dotierstoffkonzentration zwischen denen des Kanal-Bereichs und denen der Quellen- und Drain-Bereiche liegen, wobei Quelle (64), Quellen-Erweiterung (57A), Kanal (53A), Drain-Erweiterung (57A) und Drain (65) Bereiche alle von einem ersten Leitfähigkeitstyp sind und aneinandergrenzen,

dadurch gekennzeichnet, dass der MESFET darüberhinaus hoch-dotierte Taschen (59A, 60A) eines zweiten Leitfähigkeitstyps aufweist, die unter den Quellen- (57A) und Drain- (58A) Erweiterungen und an diese angrenzend angeordnet sind.

2. Ein MESFET wie in Anspruch 1 beansprucht, in welchem das Halbleitersubstrat (50) aus Galliumarsenid besteht.

3. Ein MESFET wie in Anspruch 1 beansprucht, in welchem der erste Leitfähigkeitstyp der n-Typ ist.

4. Ein MESFET wie in Anspruch 1 beansprucht, in welchem die Dotierstoffkonzentration des Kanals-Bereichs (53A) im Bereich von $1 \times 10^{16}$ bis $5 \times 10^{16}$ Atome/cm$^3$ liegt.

5. Ein MESFET wie in Anspruch 1 beansprucht, in welchem die Dotierstoffkonzentration in den Quellen- und Drain-Erweiterungen (57A, 58A) im Bereich von $1 \times 10^{17}$ bis $1 \times 10^{18}$ Atome/cm$^3$ liegt.

6. Ein MESFET wie in Anspruch 1 beansprucht, in welchem die Dotierstoffkonzentration in den Quellen- (64) und Drain- (65) Bereichen höher als $1 \times 10^{18}$ Atome/cm$^3$ ist.

7. Ein MESFET wie in Anspruch 1 beansprucht, in welchem die Dotierstoffkonzentration in den Taschen (59, 60) höher als $1 \times 10^{18}$ Atome/cm$^3$ ist.

8. Ein Prozess zum Herstellen eines MESFET auf einem halbisolierenden Galliumarsenid Substrat bestehend aus den Schritten

EP 0 175 864 B1

a) Bilden einer relativ dünnen, niedrig dotierten Schicht (53) eines ersten Leitfähigkeitstyps auf dem Substrat (50);

b) Bilden einer leitenden Gateelektrode (54) mit einer im wesentlichen horizontalen oberen Oberfläche und mit im wesentlichen vertikalen Seitenflächen, die in direktem Kontakt mit der aktiven Schicht (53) steht und über einen Teil derselben liegt;

c) Bilden einer ersten durchgehenden dielektrischen Schicht (55) auf der resultierenden Struktur;

d) Gerichtetes Ätzen mittels reaktivem Ionenätzen, um die erste dielektrische Schicht (55) weitgehend zu entfernen, wodurch dünne erste dielektrische Seitenwände (56–56) auf den vertikalen Seitenflächen des Gates (54) bestehen bleiben;

e) Bilden von Quellen- (57) und Drain- (58) Erweiterungen durch Einbringen eines Dotierstoffes eines ersten Leitfähigkeitstyps in die Teile der aktiven Schicht (53), die nicht vom Gate (54) und dessen erste dielektrische Seitenwände (56–56) bedeckt sind, wobei die Erweiterungen eine Tiefe und eine Dotierstoffkonzentration erhalten, die grösser sind als die der aktiven Schicht;

f) Bilden von Taschenbereichen (59, 60) eines zweiten Leitfähigkeitstyps unter den Quellen- (57) und Drain- (58) Erweiterungen durch Einbringen eines Dotierstoffes eines zweiten Leitfähigkeitstyps in den Halbleiterkörper (50) durch die Quellen- und Drain-Erweiterungen, derart, dass die Taschenbereiche eine Dotierstoffkonzentration erhalten, die höher ist als die der Quellen- und Drain-Erweiterungen;

g) Bilden einer zweiten durchgehenden dielektrischen Schicht (61) auf der resultierenden Struktur;

h) Gerichtetes Ätzen mittels reaktivem Ionenätzen, um die zweite dielektrische Schicht zu entfernen, wodurch zweite dielektrische Seitenwände (62–62) gebildet werden, die auf den ersten dielektrischen Seitenwänden (56–56) aufliegen, und

i) Bilden von Quellen- (64) und Drain- (65) Bereichen des ersten Leifähigkeitstyps durch Einbringen von Dotierstoff des ersten Leitfähigkeitstyps in die Teile der Quellen- (57) und Drain- (58) Erweiterungen und der darunterliegenden Taschenbereiche (59, 60) vom zweiten Leitfähigkeitstyps, die nicht von den zweiten dielektrischen Seitenwänden (62–62) bedeckt sind, derart, dass die Quellen- und Drain-Bereiche eine Tiefe und eine Dotierstoffkonzentration erhalten, die über denen der abgedeckten Quellen- und Drain-Erweiterungen liegen (57A, 58A).

9. Ein Prozess wie in Anspruch 8 beansprucht mit den weiteren Schritten

j) Bilden einer Platinschicht (66) auf der resultierenden Struktur;

k) Niedrigtemperatur-Wärmebehandlung der Struktur, um den unteren Bereich der Platinschicht, der mit den Quellen- (64) und Drain- (65) Bereichen in Kontakt steht, zu aktivieren wodurch selbstjustierende Platin-Diarsenide Kontakte mit den Quellen- und Drain-Bereichen gebildet werden, und

l) Enfernen des nicht umgesetzten Platins.

**Revendications**

1. Transistor à effet de champ métal-semiconducteur (MESFET) auto-aligné, comportant, sur un substrat semiconducteur semi-isolant (50):

– un couple de régions de source et de drain (64, 65) relativement profondes et fortement dopées,

– une région active de canal (53A) relativement peu profonde et légèrement dopée, disposée entre lesdites régions de source et de drain et sur laquelle se trouve déposée une électrode de grille conductrice, et

– un prolongement (57A) de la source et un prolongement (58A) du drain, disposés entre ladite région de canal et respectivement lesdites régions de source et de drain et dont la profondeur et la concentration de substance dopante sont comprises entre celles de la région du canal et des régions de source et de drain, lesdites régions (64) de la source, (57A) du prolongement de la source, (53A) du canal, (58A) du prolongement du drain et (65) du drain possédant toutes un premier type de conductivité et étant disposées de manière à être adjacentes,

caractérisé en ce que le transistor MESFET comporte en outre des poches fortement dopées (59A, 60A) possédant un second type de conductivité et disposées au-dessous de chacun desdits prolongements (57A, 58A) de la source et du drain en étant respectivement contiguës auxdites régions de source et de drain.

2. Transistor MESFET selon la revendication 1, dans lequel ledit substrat semiconducteur (50) est constitué par de l'arseniure de gallium.

3. Transistor MESFET selon la revendication 1, dans lequel ledit premier type de conductivité est le type n.

4. Transistor MESFET selon la revendication 1, dans lequel la concentration de substance dopante dans ladite région de canal (53A) se situe dans la gamme comprise entre $1 \times 10^{16}$ et $5 \times 10^{16}$ atomes/cm$^3$.

5. Transistor MESFET selon la revendication 1, dans lequel la concentration de substance dopante dans lesdits prolongements (57A, 58A) de la source et du drain est située dans la gamme comprise entre $1 \times 10^{17}$ et $1 \times 10^{18}$ atomes/cm$^3$.

6. Transistor MESFET selon la revendication 1, dans lequel la concentration de substance dopante dans lesdites régions (64, 65) de la source et du drain est supérieure à $1 \times 10^{18}$ atomes/cm$^3$.

7. Transistor MESFET selon la revendication 1, dans lequel la concentration de substance dopante dans lesdites poches (59, 60) est supérieure à 1 x $10^{18}$ atomes/$cm^3$.

8. Procédé pour fabriquer un transistor MESFET sur un substrat en arseniure de gallium semi-isolant, ledit procédé incluant les étapes consistant à:

a) former une couche (53) relativement peu profonde et faiblement dopée et possédant un premier type de conductivité sur ledit substrat (50);

b) former une électrode de grille conductrice (54) possédant une surface supérieure sensiblement horizontale et des surfaces latérales sensiblement verticales, et placée en contact direct avec et au-dessus d'une partie de ladite couche active (53);

c) former une première couche diélectrique de forme adaptée (55) au-dessus de la structure obtenue;

d) mettre en œuvre une corrosion directionnelle en utilisant une corrosion ionique réactive pour éliminer sensiblement ladite première couche diélectrique (55), en formant des parois latérales (56–56) du premier diélectrique, possédant de faibles dimensions, sur lesdites surfaces verticales de la grille (54);

e) former les régions (57, 58) formant prolongements de la source et du drain en introduisant une substance dopante possédant le premier type de conductivité dans la partie de la couche active (53) non masquée par ladite grille (54) et ses parois latérales associées (56–56) du premier diélectrique, lesdites régions formant prolongements ayant une profondeur et une concentration de dopage dépassant celles de la couche active;

f) former des régions de poche (59, 60) d'un second type de conductivité sous les régions constituant des prolongements (57, 58) de la source et du drain en introduisant une substance dopante possédant un second type de conductivité dans ledit corps semiconducteur (50) par l'intermédiaire desdites régions formant prolongements de la source et du drain, lesdites régions en forme de poches possédant une concentration de dopage dépassant celle des régions formant prolongements de la source et du drain;

g) former une seconde couche diélectrique de forme adaptée (61) sur la structure obtenue;

h) mettre en œuvre une corrosion directionnelle en utilisant une corrosion ionique réactive pour éliminer sensiblement ledit second diélectrique, en formant des parois latérales (62–62) du second diélectrique, venant en contact avec lesdites parois latérales (56–56) du premier diélectrique; et

i) former des régions de source et de drain (64, 65) possédant ledit premier type de conductivité en introduisant une substance dopante possédant le premier type de conductivité dans les parties des régions formant prolongements (57, 58) de la source et du drain, et des régions en forme de poches sous-jacentes (59, 60) possédant le second type de conductivité, non masquées par les parois latérales (62–62) du second diélectrique, lesdites régions de source et de drain possédant une profondeur et une concentration de dopage dépassant celles des régions masquées (57A, 58A) formant prolongements de la source et du drain.

9. Procédé selon la revendication 8, caractérisé en ce qu'il inclut en outre les étapes consistant à:

j) former une couche (66) de platine sur la structure obtenue;

k) soumettre ladite structure à une étape de chauffage à basse température de manière à faire réagir la partie inférieure de la couche de platine en contact avec lesdites régions de source et de drain (64, 65), ce qui conduit à la formation des contacts ohmiques auto-alignés de diarseniure de platine avec lesdites régions de source et de drain; et

l) éliminer le platine n'ayant pas réagi.

EP 0 175 864 B1

FIG. 1 (PRIOR ART)

FIG. 2 (PRIOR ART)

FIG. 3

FIG. 3A

FIG. 3B

FIG. 3C

57(N)  59(P)  56  54  53A(N-)  56  58(N)  60(P)  61  51

51  50

FIG. 3D

64  59A(P)  57A(N)  62  56  54  53A(N-)  56  62  58A(N)  60A(P)  65  51

51  N+  N+  50

FIG. 3E

64  59A(P)  57A(N)  63  54  53A(N-)  63  58A(N)  60A(P)  65  66

51  N+  N+  51  50

FIG. 3F